# EUROPÄISCHE PATENTSCHRIFT

(11) **EP 0 239 085 B1**
(45) Veröffentlichungstag und Bekanntmachung des Hinweises auf die Patenterteilung: **21.07.1993**
(21) Anmeldenummer: 87104373.3
(22) Anmeldetag: 25.03.1987
(51) Int. Cl.: H01L 41/08, G01N 27/00, H01L 21/68

(54) **Bewegungseinrichtung zur Mikrobewegung von Objekten**
Device for micro-movement of objects
Dispositif pour micromouvement d'objets

(30) Priorität: 27.03.1986 DE 3610540
(43) Veröffentlichungstag der Anmeldung: 30.09.1987
(73) Patentinhaber: FORSCHUNGSZENTRUM JÜLICH GMBH, 52425 Jülich (DE)
(72) Erfinder: Besocke, Karl-Heinz, D-5170 Jülich (DE)

(56) Entgegenhaltungen:
- EP-A- 0 010 983
- US-A- 4 087 715
- IRE TRANSACTIONS ON AUDIO, Band AU-7, Nr. 1, Januar-Februar 1959, Seiten 96-100, The Professional Group on Audio, New York, US; C.P. GERMANO: "A study of a two-channel cylindrical PZT ceramic transducer for use in stereo phonograph cartridges"
- REVIEW OF SCIENTIFIC INSTRUMENTS, Band 41, Nr. 1, Januar 1970, Seiten 135-136, Woodbury, NY, US; H.F. BLAZEK et al.: "Sample holder with electrical contacts for scanning electron microscope"
- MICROSCOPIE ELECTRONIQUE 1970, RESUMES DES COMMUNICATIONS PRESENTEES AU SEPTIEME CONGRES INTERNATIONAL, Grenoble, 30. August - 5. September 1970, pages 399-400, Société Française de Microscopie Electronique; H. HASHIMOTO et al.: "Morphology and structure of Mo-oxides formed by thermal decomposition of the ammonium salt"
- IBM TECHNICAL DISCLOSURE BULLETIN, Band 27, Nr. 10B, März 1985, Seiten 5976-5977, New York, US; "Fast Scan piezo drive"
- REVIEW OF SCIENTIFIC INSTRUMENTS, Band 57, Nr. 8, Teil 1, August 1986, Seiten 1688-1689, American Institute of Physics, Woodbury, NY, US; G. BINNING et al.: "Single-tube three-dimensional scanner for scanning tunneling microscopy"

## Beschreibung

Die Erfindung bezieht sich auf eine Bewegungseinrichtung für rastermikroskopisch zu untersuchende Objekte mit piezoelektrisch bewegbarer Rasternadel.

Bei Untersuchungen mit dem Raster-Tunnel-Mikroskop (RTM) von G. Binnig und H. Rohrer sind sehr präzise Mikrobewegungen der Objekte notwendig, vgl. Helvetia Phys. Acta 55, 1982, S. 726. Das RTM erfordert ein Höchstmaß an Präzision und Stabilität für die Bewegung des jeweils zu untersuchenden Objektes. Sowohl für das Abrastern des Objektes als auch für die Objektmanipulation sind Präzisionsbewegungen im Nanometerbereich für das Erzielen gewünschter Ergebnisse Voraussetzung, wobei die Bewegungen zuverlässig, reproduzierbar und rasch durchgeführt und gesteuert werden müssen.

Die bisher bekannten Stellelemente für RTM's verwenden eine Kombination von drei piezoelektrischen Stellgliedern für die Rasterung (ein Dreibein mit je einem Stellglied in den drei Koordinatenrichtungen x, y, z) und weitere Stellglieder für die Objektmanipulation, die entweder piezoelektrisch, elektronmagnetisch oder mechanisch arbeiten, G. Binning und H. Rohrer, "Das Raster-Tunnelmikroskop", Spektrum der Wissenschaft, 1985, S. 62/68; J. Moreland et al, "Electromagnetic Squeezer for Compressing Squeezable Electron Tunnel Junctions", Rev. Sci. Instrum. 53, 1984, S. 399. Diese in ihrem Aufbau komplexen Stellelemente sind störanfällig, Vibration und Temperaturdrift lassen sich kaum vermeiden. Kritisch sind auch die für den Betrieb der Piezokeramiken notwendigen hohen Spannungen.

Aufgabe der Erfindung ist es, eine Einrichtung für Bewegungsabläufe zu schaffen, die sich durch hohe Stabilität, eine präzise Steuerung der Bewegung, einfachen Aufbau, geringe Vibrationsanfälligkeit und geringe Temperaturdrift auszeichnet.

Diese Aufgabe wird bei einer Bewegungseinrichtung der eingangs angegebenen Art durch die in Patentanspruch 1 angegebenen Merkmale gelöst. Danach ist das Objekt auf drei gleichartig ausgebildeten piezoelektrisch einstellbaren Bewegungselementen gelagert, die das Objekt abstützen. Die Bewegungselemente sind mit der Rasternadel des RTM's ortsfest verbunden. Die Bewegungselemente werden durch Anlegen elektrischer Spannung am piezoelektrischen Material verformt. Durch Variation der Spannung lassen sich die Bewegungselemente in ihrer Lage jeweils derart verändern, daß sich das von den Bewegungselementen abgestützte Objekt in einer gewünschten Richtung innerhalb der durch Auflage des Objekts auf den Bewegungselementen vorgegebenen Ebene bewegt. Diese Bewegung kann rein translatorisch sein, das Objekt kann von den Bewegungselementen aber auch um eine Achse gedreht oder gekippt werden. Hierzu ist jedes piezoelektrische Bewegungselement gesondert ansteuerbar.

Die Bewegungselemente sind hohlzylinderartig ausgebildet und stirnseitig mit einer Auflage für das Objekt versehen. Ein solches zylindrisches Bewegungselement weist eine hohe mechanische Steifigkeit auf. Zur Ansteuerung der Bewegungselemente sind auf einer ihrer Zylinderwände ein geschlossener elektrisch leitfähiger Belag und auf ihrer anderen Zylinderwand mehrere, gegeneinander elektrisch isolierte, elektrisch leitfähige Teilbeläge angeordnet. Die gegeneinander isolierten Teilbeläge erstrecken sich in Richtung der Zylinderachse des Bewegungselements. Durch Anlegen einer Spannung zwischen den Belägen auf beiden Zylinderwänden wird eine Verkürzung oder Dehnung des Bewegungselementes erreicht. Zum Verbiegen des Bewegungselementes ist eine Spannung zwischen den geschlossenen Belag und einem Teilbelag anzulegen. Solche Bewegungselemente sind aus US-A-4 087 715 bekannt.

Man kann somit durch Überlagerung der angelegten Spannungen alle für die Bewegung des Objektes erforderlichen Lageveränderungen ausführen, wobei die hierfür notwendigen elektrischen Spannungen wegen der mit verhältnismäßig geringer Wandstärke ausführbaren Bewegungselementen entsprechend klein gehalten werden können.

Die starre Verbindung zwischen Bewegungselementen und Rasterelement führt zu einer geschlossenen kompakten Baueinheit mit hoher mechanischer Stabilität und Temperaturunempfindlichkeit bei der Raster-Tunnel-Mikroskopie. Nach Patentanspruch 2 ist das Rasterelement in gleicher Weise wie ein Bewegungselement ausgebildet. Es besteht somit insbesondere aus hohlzylindrischem piezoelektrischen Material, das auf seiner inneren und äußeren Zylinderwand mit elektrisch leitenden Belägen bzw. Teilbelägen versehen ist. Diese analoge Ausbildung von Rasterelement und Bewegungselementen führt beim Einsatz der Bewegungseinrichtung bei einem RTM zu weitgehender Vibrationsfreiheit und zur Kompensation der Temperaturdrift. Der gleiche Aufbau von Bewegungselementen und Rasterelement ermöglicht es auch, die für die RTM-Anwendung notwendige Rasterbewegung statt mit dem Rasterelement mit den Bewegungselementen auszuführen. Zur Temperaturmessung des Objekts ist zumindest eines der Bewegungselemente mit einem Thermofühler ausgestattet, Patentanspruch 3.

Aus herstellungstechnischen Gründen sind die gegeneinander isolierten, elektrisch leitenden Teilbeläge bevorzugt auf der äußeren Zylinderwand eines Bewegungselementes angeordnet, Patentanspruch 4.

Eine optimale elektrische Steuerung der Bewegungselemente ist nach Patentansprüchen 5 und 6 dann gegeben, wenn jeder elektrisch leitende Belag auf den Zylinderflächen eines Bewegungselementes gesondert ansteuerbar ist. Die Objektbewegung läßt sich dann jeweils durch unterschiedliche elektrische Betriebsspannungen an den Belägen optimal regulieren. Eine Justierung der Ruhelage der Bewegungselemente läßt sich durch Anlegen einer Gleichspannung erreichen, die von der für den Betrieb erforderlichen Wechselspannung überlagert wird.

Die Erfindung und weitere Erfindungsmerkmale werden im folgenden anhand von Ausführungsbeispielen näher erläutert. Die Zeichnung zeigt im einzelnen:
- Figur 1: Bewegungseinrichtung als Objektträger und Rasterelement bei einem Raster-Tunnel-Mikroskop (RTM);
- Figur 2: Bewegungselement in perspektivischer Darstellung und im Querschnitt (Figur 2a);
- Figur 3: Bewegungsabläufe der Bewegungselemente bei einer Objektmanipulation: mit vom Objekt abhebendem Bewegungselement (Fig. 3a) mit rutschender Bewegung des Bewegungselementes auf der Objektoberfläche (Fig. 3b);
- Figur 4: Transporteinrichtung zur Mikrobewegung von Objekten über eine größere Distanz;
- Figur 5: Rasterelement in perspektivischer Darstellung und im Querschnitt (Fig. 5a);
- Figur 6: Bewegungselemente mit Thermofühler und Potentialzuführung sowie Rasterelement im Längsschnitt;
- Figur 7: Bewegungselement in perspektivischer Darstellung mit Auflagestützen für das Objekt;
- Figur 8: Bewegungselement mit drei Außenelektroden in perspektivischer Darstellung und im Querschnitt (Fig. 8a).

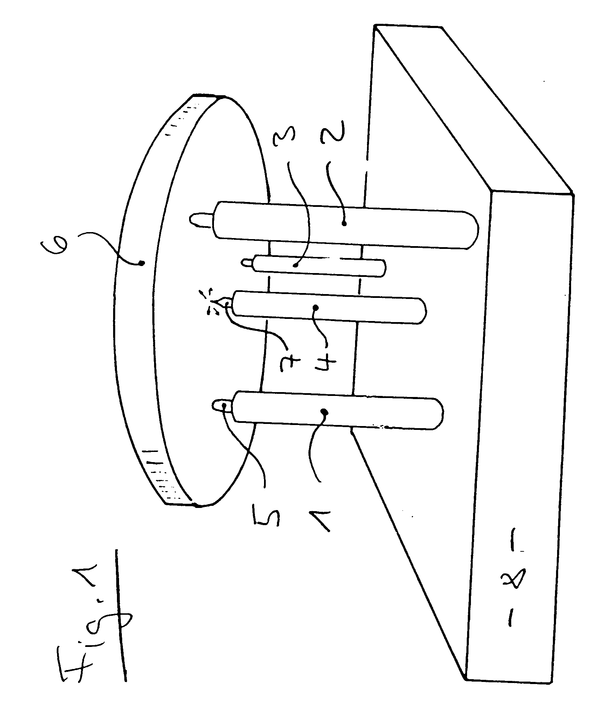

Figur 1 zeigt eine aus drei Bewegungselementen 1, 2, 3 bestehende Bewegungseinrichtung für ein Raster-Tunnel-Mikroskop (RTM) mit einem hier zentral zwischen den Bewegungselementen 1, 2, 3 angeordnetem Rasterelement 4 zur Messung des Tunnelstroms. Die Bewegungselemente 1, 2, 3 sind im Ausführungsbeispiel in gleichem Abstand zueinander angeordnet. Alle Bewegungselemente 1, 2, 3 und das Rasterelement 4 weisen den gleichen Aufbau auf. Für die Ausbildung der Elemente wurden im Ausführungsbeispiel zylinderförmige Teile aus piezoelektrischem Material, beispielsweise Piezokeramik, verwendet, wobei die Bewegungselemente stirnseitig mit einer Auflage 5 für ein mit dem RTM zu untersuchendes Objekt 6 und das Rasterelement 4 mit einer Abtastnadel 7 (Tunnelspitze) versehen sind. Die Bewegungselemente 1, 2, 3 und das Rasterelement 4 sind im Ausführungsbeispiel an einer gemeinsamen Grundplatte 8 befestigt. An jedes der Elemente sind variierbare Spannungen bzw. durch stetiges Verändern der Spannungen Spannungsverläufe anlegbar, die eine Verkürzung oder Verlängerung oder ein Verbiegen des keramischen Materials bewirken.

Das Objekt 6 ruht auf den im Ausführungsbeispiel kugelförmig ausgebildeten Auflagen 5 der Bewegungselemente 1, 2, 3. Durch diese Dreipunktunterstützung des Objektes 6 ist eine stabile Auflage für das Objekt gewährleistet. Ist dies allein durch Schwerkraftwirkung nicht zu erreichen, kann das Objekt auch mittels Federkraft auf die Auflagen 5 der Bewegungselemente aufgedrückt werden.

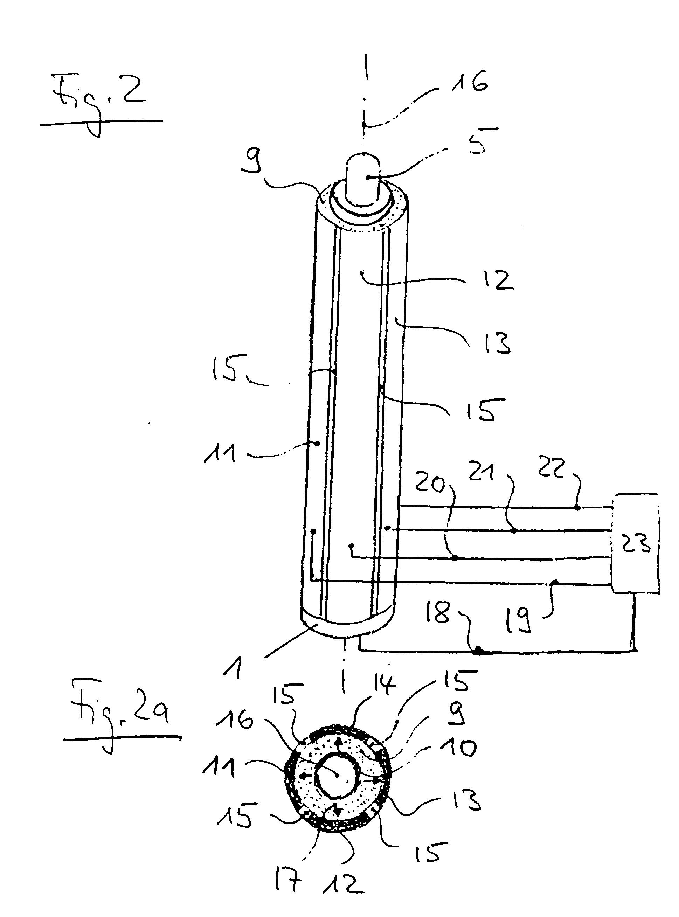

Der Aufbau eines Bewegungselementes 1, 2 oder 3 wird anhand von Figur 2 erläutert. Figur 2 zeigt ein Bewegungselement mit aufgesetzter Auflage 5 in perspektivischer Darstellung. Ein Querschnitt des Bewegungselementes ist in Figur 2a wiedergegeben. Für die Ausbildung des Bewegungselementes wurde ein Rohr 9 aus piezokeramischen Material verwendet. Im Ausführungsbeispiel weist das piezokeramische Rohr einen Außendurchmesser von 2 mm und einen Innendurchmesser von 1 mm auf. Auf seiner inneren Zylinderwand ist das piezokeramischen Rohr 9 mit einem geschlossenen, elektrisch leitfähigen Belag 10 als Innenelektrode versehen. Die äußere Zylinderwand des Bewegungselementes trägt vier elektrisch leitfähige Teilbeläge 11 bis 14, die als Streifenelektroden mittels Isolationen 15 gegeneinander elektrisch isoliert sind. Die Teilbeläge 11 bis 14 sind auf der äußeren Zylinderwand parallel zur Achse 16 des Bewegungselementes verlegt, die Isolationen 15 verlaufen in Achsrichtung. Im Ausführungsbeispiel ist das piezoelektrische Material radial polarisiert, wie es in Figur 2a durch Pfeile 17 markiert ist.

Am inneren Belag 10 und an den Teilbelägen 11 bis 14 sind elektrische Leitungen 18 bis 22 angeschlossen, über die am Bewegungselement Spannungen bzw. Spannungsverläufe anlegbar sind. Die erforderlichen Spannungen für die Bewegungen des Bewegungselementes in X-, Y-, Z-Richtung werden von einem regelbaren Spannungsgeber 23 erzeugt.

Werden alle Teilbeläge 11 bis 14 auf gleiches elektrisches Potential gebracht und wird zwischen diesen und dem inneren Belag 10 eine Spannungsdifferenz angelegt, so deformiert sich das Bewegungselement in Achsrichtung, d.h. es verlängert oder verkürzt sich in Z-Richtung, je nach Polarität der angelegten Spannung. Wird jedoch zwischen einzelnen Teilbelägen und innerem Belag 10 des piezoelektrischen Rohres 9 eine Spannung angelegt, so verbiegt sich das freie Ende des Bewegungselementes mit der Auflage 5 senkrecht zu seiner Achse 16 in X- oder Y-Richtung. Die Verbiegung wird verstärkt, wenn Spannungen entgegengerichteter Polarität zwischen den auf der aüßeren Zylinderwand gegenüberliegenden Teilbelägen angelegt werden, also beispielsweise zwischen den Teilbelägen 11 und 13 oder 12 und 14, wobei der innere Belag 10 auf Potential Null liegt.

Durch Überlagern der vorgenannten Spannungen läßt sich das Bewegungselement somit derartig verformen, daß die Auflage 5 jede für eine gewünschte Lagerveränderung des Objekts erforderliche Bewegung ausführt, wobei die hierfür notwendigen Betriebsspannungen wegen der Abmessungen und dünnwandigen Ausführung des Bewegungselementes relativ klein sind.

Die Bewegungselemente 1, 2, 3 und das Rasterelement 4 sind in ihrem Niveau zueinander in der Grundplatte 8 so justiert, daß die Abtastnadel 7 des Tasterelementes bei Auflegen des Objektes 6 auf die Auflagen 5 der Bewegungselemente einen hinreichend geringen Abstand von der zu untersuchenden Objektoberfläche aufweist. Eine Feineinstellung des Abstandes zwischen Abtastnadel und Objektoberfläche wird dann durch Anlegen einer entsprechenden Spannung an Bewegungselementen und/oder am Rasterelement vorgenommen. Die Anordnung von Bewegungselementen und Rasterelement auf derselben Grundplatte und die für die Bewegungselemente und das Rasterelement gewählte identische Ausbildung aus gleichem piezokeramischen Material und mit gleicher Abmessung führen für Bewegungselemente und Rasterelement zu gleichem thermischen Ausdehnungsverhalten, so daß zwischen Objektoberfläche und Rasterelement die Temperaturausdehnung kompensiert wird.

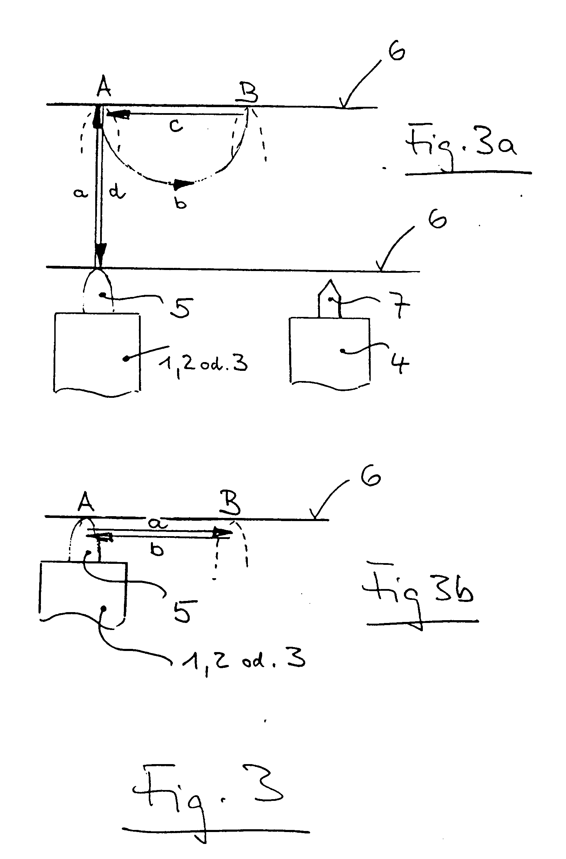

Um eine Verschiebung oder Drehung des Objektes zu erreichen, zeigt Figur 3 schematisch zwei mögliche Bewegungsabläufe für die Bewegungselemente:

Figur 3a zeigt einen Bewegungsablauf, bei dem zum Transport eines Objektes von einem Punkte A bis zu einem Punkte B die Auflage 5 eines Bewegungselementes in vier aufeinanderfolgenden Arbeitsschritten wie folgt bewegt wird:
a) Durch synchrones und einheitliches Verlängern aller drei Bewegungselemente 1, 2, 3 wird das Objekt im ersten Schritt a zunächst in Z-Richtung aus der Arbeitsposition der Abtastnadel 7 abgehoben.
b) Im zweiten Schritt b werden die Bewegungselemente in Z-Richtung rasch abgesenkt, dabei in der X-Y-Ebene geschwenkt und wieder angehoben, so daß sich als Bewegungslinie etwa eine Halbkreisbahn ergibt. Dieser zweite Schritt b wird in seinem Ablauf so gesteuert, daß die Geschwindigkeit des Absenkens der Auflage 5 in Z-Richtung größer ist als eine Bewegung des Objektes in gleicher Richtung unter Einwirkung der Schwerkraft. Die Auflagen 5 der Bewegungselemente lösen sich bei diesem zweiten Arbeitsschritt im Punkt A vom Objekt, das aufgrund seiner Trägkeit praktisch in seiner Position verharrt, und unterstützen es am Ende des Arbeitsschrittes im Punkt B erneut.
c) Als dritter Schritt c folgt dann eine langsame Bewegung der Auflage 5 in der X-Y-Ebene, wobei das Objekt auf den drei Bewegungselementen ruhen bleibt und in Richtung der Bewegung der Bewegungselemente um eine Strecke transportiert wird, die dem Abstand zwischen den Punkten A und B entspricht.
d) Um wieder in die Arbeitsposition für die Abtastnadel 7 zu gelangen, bedarf es als vierten Arbeitsschritt d noch einer Absenkung des Objektes in Z-Richtung. Am Ende dieses Arbeitsschrittes befinden sich die Bewegungselemente wieder in ihrer Ausgangsposition und das Objekt ist um die Strecke zwischen den Punkten A und B verschoben worden.

Die Arbeitsschritte b und c lassen sich beliebig wiederholen, so lange, bis das Objekt die für die RTM-Untersuchung gewünschte Arbeitsstellung erreicht hat. Anschließend erfolgt dann Arbeitsschritt d zum Heranführen des Objekts an die Abtastnadel 7.

Ein gegenüber dem vorbeschriebenen Verfahren vereinfachter Bewegungsablauf für die Bewegungselemente ist in Figur 3b wiedergegeben. Die Bewegungselemente werden danach in nur zwei Arbeitsschritten gesteuert:
a) Als erster Schritt a erfolgt eine schnelle Bewegung der Auflage 5 auf der Objektoberfläche vom Punkt A nach Punkt B. Bei dieser Bewegung der Bewegungselemente bleibt das Objekt aufgrund seiner Massenträgheit wieder in nahezu unveränderter Position.
b) Beim zweiten Schritt b wird das Bewegungselement in seine Ausgangsposition zurückgeholt, wobei das Objekt bei langsamer Bewegung des Bewegungselementes um die zwischen den Punkten A und B liegende Strecke transportiert wird.

Jeder der in Fig. 3a und 3b wiedergegebene Bewegungsablauf kann einzeln oder bei einer an den Bewegungselementen angelegten Spannungsimpulsfolge in Schritten, die sich kontinuierlich wiederholen, fortlaufend durchgeführt werden. Schrittweite und Schrittfrequenz der Auflagen der Bewegungselemente lassen sich in weiten Grenzen durch entsprechende Wahl von Spannungsamplitude und Impulsfrequenz variieren. Mit den piezoelektrischen Bewegungselementen lassen sich Schritte mit einer Schrittweite von weniger als 10 nm reproduzierbar ausführen.

Die mit den Bewegungselementen ausführbaren Bewegungsabläufe sind auf die in Fig. 3a und 3b wiedergegebenen Bewegungen nicht beschränkt. Vielmehr läßt sich die Bewegung der Bewegungselemente dem jeweiligen Anwendungsfall entsprechend anpassen. Beispielsweise sind neben den vorbeschriebenen Bewegungsabläufen auch ellipsenförmige Bewegungen der Auflagen oder ein Hochwerfen des Objekts mit schnellem Ortswechsel der Auflagen möglich. Die Steuerung der Bewegungsabläufe erfolgt dabei unter Berücksichtigung der Massenträgheit des Objekts.

Mit der beschriebenen Bewegungseinrichtung ist auch eine Drehung der Objekte um eine Achse senkrecht zur Auflagenebene möglich. Das Drehen der Objekte erfolgt durch entsprechende vektorielle Addition der Spannungen in X- und Y-Richtung für jedes einzelne Bewegungselement. Darüberhinaus lassen sich die Objekte auch kippen. Hierzu sind die einzelnen Bewegungselemente unterschiedlich zu strecken oder zu verkürzen. Die Bewegungseinrichtung erlaubt somit neben translatorischen Bewegungen auch ein Drehen und Kippen der Objekte.

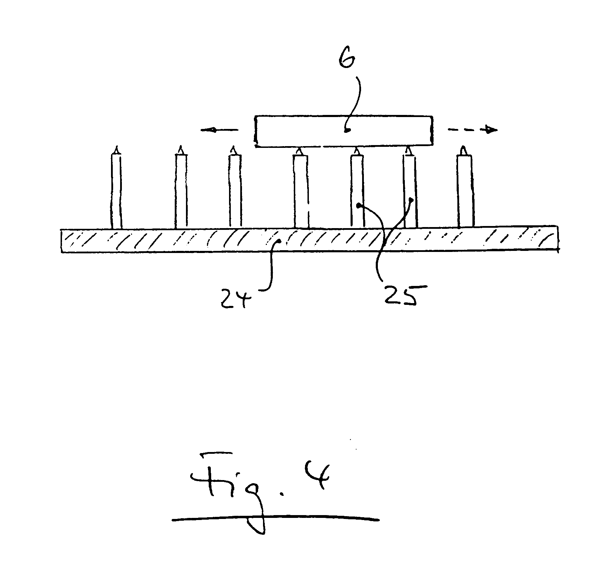

Mit den Bewegungselementen der angegebenen Art können Objekte aber auch über weitere Entfernung mit hoher Präzision transportiert werden. Einen Transporttisch 24 mit mehreren benachbart zueinander angeordneten Bewegungselementen 25 zeigt Figur 4. Die Bewegungselemente weisen untereinander einen solchen Abstand auf, daß das zu bewegende Objekt in jeder Position zumindest von drei Bewegungselementen gestützt ist und in beliebiger Weise auf dem Transporttisch 24 verschoben werden kann.

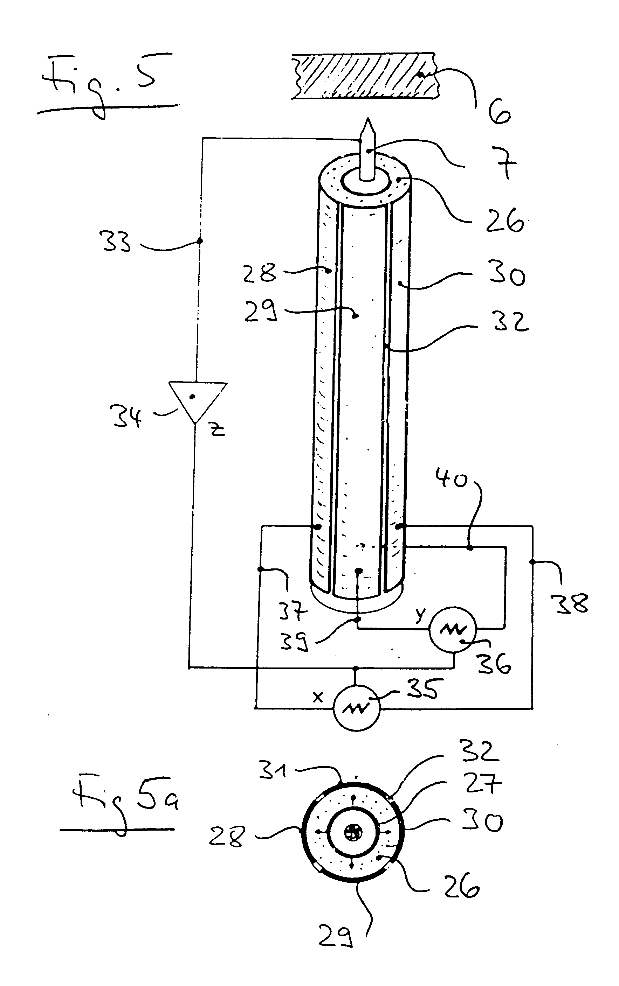

Figur 5 zeigt in perspektivischer Darstellung ein Rasterelement 4 der in Figur 1 gezeigten Bewegungseinrichtung für ein RTM. Das Rasterelement ist in gleicher Weise wie ein Bewegungselement ausgebildet. Es weist ein Rohr 26 aus demselben, radial polarisiertem piezoelektrischen Material auf wie das Rohr 9 in Fig. 2 und ist auf seiner inneren Zylinderwand mit einem geschlossenen, elektrisch leitfähigen Belag 27 als Innenelektrode und auf seiner äußeren Zylinderwand mit elektrisch leitfähigen Teilbelägen 28 bis 31 versehen, zwischen denen in axialer Richtung jeweils eine Isolationsschicht 32 verläuft. Im Gegensatz zu einem Bewegungselement ist jedoch statt einer Auflage 5 beim Rasterelement 4 die Abtastnadel 7 eingesetzt.

Figur 5 zeigt schematisch auch die elektrischen Anschlüsse für das Rasterelement 4. Der im Betriebsfall von der Abtastnadel 7 abgegriffene Tunnelstrom wird über eine an der Abtastnadel 7 angeschlossene elektrische Leitung 33 abgeführt und in einem Verstärker 34 verstärkt. Die Ausgangsspannung des Verstärkers wird zur Bewegung des Rasterelementes in Z-Richtung (Achsrichtung) benutzt.

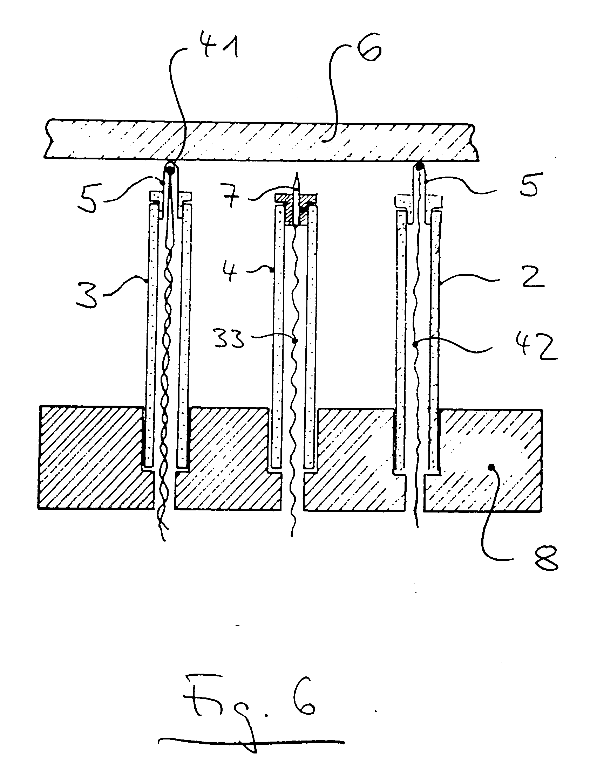

Für die Steuerung der Abtastnadel in der X-und Y-Ebene dienen zwei Rampengeneratoren 35, 36. Das Basispotential dieser Generatoren ist überlagerbar durch eine regulierbare Spannung für die Z-Richtung. Im Ausführungsbeispiel ist der Ausgang des Rampengenerators 35 über Anschlüsse 37, 38 mit den Teilbelägen 28 und 30, der Ausgang des Rampengenerators 36 über Anschlüsse 39, 40 mit den Teilbelägen 29, 31 des Rasterelementes verbunden. Der innere geschlossene Belag 27, die Innenelektrode, ist im Ausführungsbeispiel auf Erdpotential gelegt. Auf diese Weise kann die Innenelektrode zugleich als Abschirmung für die elektrische Leitung 33 dienen. Figur 6 zeigt die im Inneren des Rasterelementes verlaufende elektrische Leitung 33, die mit der Abtastnadel 7 verbunden ist. Die Verstärkung und Aufzeichnung des Tunnelstromes erfolgt in der bei RTM's üblichen, bekannten Weise.

Die Temperatur der Objektoberfläche läßt sich über einen Thermofühler 41 messen, der in einem der Bewegungselemente, im Ausführungsbeispiel im Bewegungselement 3 (s. Figur 6), verlegt ist. Im Ausführungsbeispiel ist als Temperaturfühler ein Thermoelement vorgesehen, das in die Auflage 5 eingesetzt ist. In Figur 6 ist auch ein Bewegungselement gezeigt, im Ausführungsbeispiel das Bewegungselement 2, in dessen Hohlraum eine Potentialzuführung 42 verlegt ist. Die Potentialzuführung 42 ist mit der Auflage 5 des Bewegungselementes verbunden. Über die Potentialzuführung ist das elektrische Potential des Objektes, das auf das Bewegungselement 2 aufgelegt wird, entsprechend einstellbar.

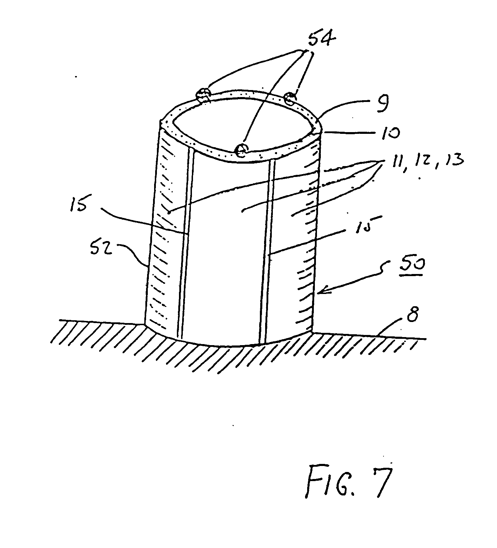

Ein weiteres Ausführungsbeispiel für ein Bewegungselement ist in Fig. 7 dargestellt. Das Bewegungselement 50 ist in seinem Aufbau ähnlich dem in Fig. 2 wiedergegebenen Bewegungselement. Es befinden sich jedoch statt der Auflage 5 in Fig. 2 beim Bewegungselement 50 auf dessen oberer Stirnfläche 51 drei halbkugelförmige Auflagestützen 52. Die Abmessungen des Bewegungselementes 50 sind in gewählt, daß beim Auflegen eines Objektes auf die Auflagestützen 52 eine stabile Objektlage erreicht wird. Das Bewegungselement 50 läßt sich somit auch als einzelne Objetstütze statt der in Fig. 1 gezeigten drei Bewegungselemente einsetzen.

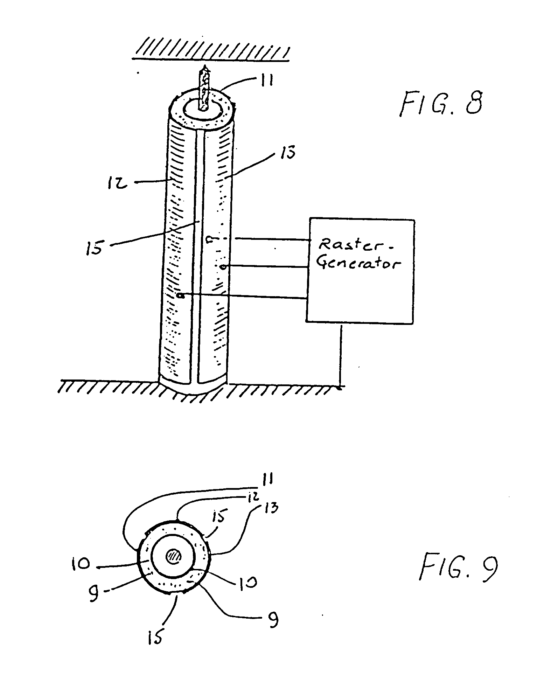

In Fig. 8 und 8a ist ein weiteres Bewegungselement 53 gezeigt, das auf dem Umfang verteilt drei Außenelektroden 54 bis 56 aufweist. Im übrigen zeigt es den gleichen Aufbau wie das in Fig. 2 dargestellte Bewegungselement. Auch mit dem Bewegungselement 53 lassen sich alle Bewegungen ausführen, wie sie in Fig. 3a und 3b wiedergegeben sind. Die jeweilige Bewegungsrichtung des Bewegungselementes bzw. die der Auflage 5 für das Objekt folgt aus den elektrischen Spannungen, die an den drei Elektroden angelegt werden.

Die im Ausführungsbeispiel beschriebene Bewegungseinrichtung ist nicht nur für die Objektbewegung beim RTM einsetzbar. Sie kann selbstverständlich darüberhinaus zur Objektmanipulation bei jeder Art von Mikrobewegung, sowohl bei mikroskopischen Untersuchungen als auch bei der Bearbeitung von Objekten in der Mikrotechnik verwendet werden. Wird sie beispielsweise bei der Mikrolithographie eingesetzt, so ist die Bewegungseinrichtung lediglich statt mit einer Abtastnadel mit einem der Bearbeitung entsprechenden Element auszurüsten. Im übrigen kann der Aufbau der Bewegungseinrichtung prinzipiell unverändert beibehalten werden.

In der modernen Hochintegrations-Technologie zur Herstellung elektronischer Schaltkreise ist man mit den bisher üblichen Methoden (Photoresistverfahren, Laser-, Elektronen- und Ionensätzen) an einer Grenze angelangt. Zur Erzeugung hoch qualifizierter Strukturen, wie sie für die moderne Mikrochip-Herstellung nötig wären, ist die Bewegungseinrichtung geeignet.

Die Bewegungseinrichtung der beschriebenen Art ist nicht nur in der Lage, nach dem RTM-Verfahren atomare Strukturen zu analysieren, sondern auch Strukturen mit lateralen Auflösungen im nm-Bereich zu erzeugen. Im einfachsten Fall kann der Aufbau einer solchen Anordnung - wie oben bereits beschrieben - ähnlich wie beim RTM erfolgen. Das zu bearbeitende Objekt ruht wieder auf mindestens 3 Trägerelementen.

Auf einem oder auch mehreren weiteren Bewegungselementen kann (statt der beim RTM eingesetzten Abtastnadel) ein geeigentes "Bearbeitungswerkzeug" montiert sein. Dieses Bearbeitungswerkzeug kann beispielsweise aus einer scharfen Spitze (z.B. Diamantspitze) bestehen, die bei entsprechender piezoelektrischer Aktivierung der Bewegungseinrichtung über die zu bearbeitende Objektoberfläche geführt werden kann und auf ihrem Wege Löcher und Strukturen auf dieser Oberfläche gräbt. Die Bewegungselemente werden zweckmäßigerweise computergesteuert. Die Operationen lassen sich somit mit hoher Geschwindigkeit und Präzision durchführen. Da mit der beschriebenen Einrichtung beliebig große Objekte in der Mikrotechnologie über große Distanzen transportiert werden können und da mehrere Bewegungselemente mit Bearbeitungswerkzeugen gleichzeitig parallel eingesetzt und betrieben werden können, kann somit eine große Fläche (z.B. ein Halbleiterwaver großer Dimension) gleichzeitig mit Mikrostrukturen versehen werden.

Als weiteres Bearbeitungswerkzeug, das an ein Bewegungselement montiert werden kann, eignet sich auch eine Feldemissionsspitze. Mit ihr können durch Elektronenemission oder Ionenemission oder auch nur aufgrund hoher elektrischer Felder Oberflächenatome eines Objektes lokal aktiviert werden. Dieser Vorgang wird z.B. zum lokalen Cracken von Kohlenwasserstoff-Verbindungen angewandt, was zu einer chemischen Umwandlung des "bearbeiteten" Moleküls führt.

Ein weiteres Anwendungsbeispiel für die beschriebene Bewegungseinrichtung mit Bearbeitungselement ist deren Einsatz in der Mikrobiologie. Organische Molekülketten, Viren oder Bakterien lassen sich nicht nur analysieren, sondern es läßt sich auch durch Anwendung von lokalen Feldern an gezielten Punkten eine Trennung oder Modifikation der Molekülketten herbeiführen. Diese Möglichkeit einer gezielten Operation im Molekülbereich eröffnet völlig neue Möglichkeiten auch auf dem Gebiet der Gentechnologie.

Eine andere Möglichkeit besteht auch darin, das Bewegungselement ähnlich einer "MAUS" einzusetzen, wie sie als elektronische Abtastgeräte bekannt sind. Dabei bleibt das zu bearbeitende Objekt ruhren, während sich das Bewegungselement über das Objekt bewegt.

## Patentansprüche

1. Bewegungseinrichtung für rastermikroskopisch zu untersuchende Objekte mit piezoelektrisch bewegbarer Rasternadel,
**dadurch gekennzeichnet,**
daß drei gleichartig ausgebildete piezoelektrisch einstellbare Bewegungselemente (1, 2, 3) als Objektstützen angeordnet und mit der Rasternadel ortsfest verbunden sind, wobei die Bewegungselemente (1, 2, 3) hohlzylinderartig ausgebildet sind und auf einer ihrer Stirnseiten eine Auflage (5) für das Objekt (6) aufweisen, und auf einer Zylinderwand einen geschlossenen, elektrisch leitfähigen Belag (10) und auf ihrer anderen Zylinderwand mehrere, gegeneinander elektrisch isolierte elektrisch leitfähige Teilbelege (11 bis 14) aufweisen, die sich auf der Zylinderwand in Richtung der Zylinderachse (16) erstrecken und durch zwischen den Teilbelegen (11 bis 14) parallel zur Zylinderachse (16) verlaufende Isolierungen (15) voneinander getrennt sind.

2. Bewegungeinrichtung nach Anspruch 1,
**dadurch gekennzeichnet,**
daß das Rasterelement (4) in gleicher Weise wie ein Bewegungselement (1, 2, 3) ausgebildet ist.

3. Bewegungseinrichtung nach Anspruch 1 oder 2,
**dadurch gekennzeichnet,**
daß zumindest eines der Bewegungselemente (3) mit einem Thermofühler (41) zur Messung der Temperatur des Objektes (6) ausgestattet ist.

4. Bewegungseinrichtung nach Anspruch 1, 2 oder 3,
**dadurch gekennzeichnet,**
daß die gegeneinander isolierten Teilbeläge (11 bis 14) auf der äußeren Zylinderwand angeordnet sind.

5. Bewegungseinrichtung nach einem der vorhergehenden Ansprüche,
**dadurch gekennzeichnet,**
daß an jeden Belag (10) bzw. Teilbelag (11 bis 14) eine gesonderte, der gewünschten Objektbewegung entsprechende elektrische Betriebsspannung anlegbar ist.

6. Bewegungseinrichtung nach einem der vorhergehenden Ansprüche,
**dadurch gekennzeichnet,**
daß der für den Betrieb erforderlichen Wechselspannung eine Gleichspannung überlagerbar ist.

7. Bewegungseinrichtung nach einem der vorhergehenden Ansprüche,
**gekennzeichnet durch**
ihre Verwendung bei der Mikrotechnik, wobei statt Abtastnadel (7) und Rasterelement (4) ein Bearbeitungselement eingesetzt ist.

## Claims

1. Device for moving objects to be examined by scanning microscope with a piezoelectrically movable scanning tip, characterised in that three piezoelectrically adjustable movement elements (1, 2, 3) of similar construction are disposed as supports for the object and are permanently connected to the scanning tip, the movement elements (1, 2, 3) being of hollow cylindrical construction and having on one of their end faces a bracket (5) for the object (6), and having on one cylinder wall a sealed, electrically conductive layer (10) and on their other cylinder wall a plurality of electrically conductive partial layers (11 to 14) which are insulated electrically from one another and which extend over the cylinder wall in the direction of the cylinder axis (16) and are separated from one another by insulations (15) running between the partial layers (11 to 14) parallel to the cylinder axis (16).

2. Movement device according to claim 1,
characterised in that the scanning element (4) is of identical construction to a movement element (1, 2, 3).

3. Movement device according to claim 1 or 2,
characterised in that at least one of the movement elements (3) is equipped with a temperature sensor (41) for measuring the temperature of the object (6).

4. Movement device according to claim 1, 2 or 3,
characterised in that the partial layers (11 to 14) which are insulated from one another are disposed on the outer wall of the cylinder.

5. Movement device according to one of the preceding claims,
characterised in that a separate electrical operating voltage corresponding to the desired movement of the object can be applied to each layer (10) or partial layer (11 to 14).

6. Movement device according to one of the preceding claims,
characterised in that a direct voltage can be superimposed on the alternating voltage required for operation.

7. Movement device according to one of the preceding claims,
characterised by its use in microengineering, a machining element being employed in place of the scanning tip (7) and scanning element (4).

## Revendications

1. Dispositif de déplacement d'objets à étudier au microscope à balayage, comprenant une pointe-sonde mobile piézoélectriquement,
caractérisé,
en ce qu'il est prévu, comme porte-objet, trois éléments de déplacement (1, 2, 3) identiques, réglables piézoélectriquement et reliés en des poins fixes à la pointesonde, les éléments de déplacement (1, 2, 3) étant constitués sous la forme de cylindres tubulaires et comportant, sur l'un de leurs côtés frontaux, un support (5) pour l'objet (6) et présentant, sur une paroi cylindrique, une couche (10) fermée et conductrice de l'électricité et, sur leur autre paroi cylindrique, plusieurs couches partielles (11 à 14) conductrices de l'électricité isolées électriquement l'une de l'autre, s'étendant sur la paroi cylindrique dans la direction de l'axe (16) du cylindre et séparées les unes des autres par des isolations (15) s'étendant entre les couches partielles (11 à 14) parallèlement à l'axe (16) du cylindre.

2. Dispositif de déplacement suivant la revendication 1,
caractérisé,
en ce que l'élément de balayage (4) est constitué de la même façon qu'un élément de déplacement (1, 2, 3).

3. Dispositif de déplacement suivant la revendication 1 ou 2,
caractérisé,
en ce qu'au moins l'un des éléments de déplacement (3) est muni d'une sonde (41) de repérage de la température de l'objet (6).

4. Dispositif de déplacement suivant la revendication 1, 2 ou 3,
caractérisé,
en ce que les couches partielles (11 à 14) isolées les unes par rapport aux autres sont disposées sur la paroi extérieure du cylindre.

5. Dispositif de déplacement suivant l'une des revendications précédentes,
caractérisé,
en ce que, sur chaque couche (10) ou sur chaque couche partielle (11 à 14), peut être appliquée une tension électrique de fonctionnement distincte correspondant au déplacement souhaité pour l'objet.

6. Dispositif de déplacement suivant l'une des revendications précédentes,
caractérisé,
en ce qu'à la tension alternative nécessaire pour le fonctionnement peut être superposée une tension continue.

7. Dispositif de déplacement suivant l'une des revendications précédentes,
caractérisé,
par son utilisation dans la technique microscopique dans laquelle on utilise un élément d'usinage au lieu de la pointe-sonde (7) et de l'élément de balayage (4).
